(19) Europäisches Patentamt
European Patent Office
Office européen des brevets

(11) **EP 3 088 882 B1**

(12) **EUROPEAN PATENT SPECIFICATION**

(45) Date of publication and mention
of the grant of the patent:
**21.07.2021 Bulletin 2021/29**

(51) Int Cl.:
**G01N 27/82** *(2006.01)* **G01N 29/44** *(2006.01)*
**G01N 29/52** *(2006.01)* **G01N 29/24** *(2006.01)*
**G01N 29/42** *(2006.01)*

(21) Application number: **14841923.7**

(22) Date of filing: **12.06.2014**

(86) International application number:
**PCT/CN2014/079703**

(87) International publication number:
**WO 2015/032231 (12.03.2015 Gazette 2015/10)**

(54) **MAGNETOSTRICTIVE WAVEGUIDE DETECTION SIGNAL PROCESSING METHOD AND DEVICE**

VERFAHREN UND VORRICHTUNG FÜR MAGNETOSTRIKTIVE
WELLENLEITERDETEKTIONSSIGNALVERARBEITUNG

PROCÉDÉ ET DISPOSITIF DE TRAITEMENT DE SIGNAL DE DÉTECTION DE GUIDE D'ONDES
MAGNÉTOSTRICTIF

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.12.2013 CN 201310723746**

(43) Date of publication of application:
**02.11.2016 Bulletin 2016/44**

(73) Proprietor: **Huazhong University of Science and
Technology
Wuhan, Hubei 430074 (CN)**

(72) Inventors:
• **WU, Xinjun
Wuhan, Hubei 430074 (CN)**
• **TANG, Mingxi
Wuhan, Hubei 430074 (CN)**
• **SUN, Pengfei
Wuhan, Hubei 430074 (CN)**

(74) Representative: **Lang, Christian
LangPatent Anwaltskanzlei IP Law Firm
Ingolstädter Straße 5
80807 München (DE)**

(56) References cited:
CN-A- 101 126 743     CN-A- 101 451 976
CN-A- 101 710 103     CN-A- 103 424 471
US-A1- 2012 119 732    US-B1- 6 497 151

• YI LU, XIN WANG, JIONG TANG: "Robust
Decision Making in Damage Detection Using
PiezoelectricTransducers and Lamb Wave
Propagation", SPIE, PO BOX 10 BELLINGHAM
WA 98227-0010 USA, 31 December 2007
(2007-12-31), XP040238743,

**Description**

The invention relates to a technical field of non-destructive testing, and more particularly to a method and a device for processing magnetostrictive guided wave detection signals.

Magnetostrictive guided waves technology has been applied in industry in recent years due to its non-contact and absence of surface polishing. For example, Chinese Patent Publication No. CN101393173A discloses a system for detecting magnetostrictive guided waves in cable-stayed anchorage zone, Chinese Patent Publication No. CN101451976A discloses a method for determining a work point in magnetostrictive guided wave detection, Chinese Patent Publication No. CN101710103A discloses a unidirectional detecting method of magnetostrictive guided waves, and Chinese Patent Publication No. CN102520057A discloses a magnetostrictive guided wave sensor for detecting the interior of a heat exchange tube and a detecting method thereof. However, low conversion efficiency and low signal to noise ratio resulted from non-contact of magnetostrictive guided waves technology restrict the technology's application, which can hardly be avoided by traditional filtering methods. Chinese Patent Publication No. CN101126743A discloses a method for improving signal to noise ratio of magnetostrictive guided waves detection signals, however, the method is extremely inconvenient in field detection for requiring defect-free samples for collecting standard signals. YI LU et al., "Robust decision making in damage detection using piezoelectric transducers and lamb wave propagation", SPIE, PO BOX 10 BELLINGHAM WA 98227-0010 USA, 31.12.2007, discloses a method of denoising the magnetostrictively generated guided wave detection signals, and the method includes the step of performing a singular value decomposition on a matrix A formed by the magnetostrictively generated guided wave detection signals so as to obtain a singular matrix B.

It is one objective of the invention to provide a method and a device for processing magnetostrictively generated guided wave detection signals. The method according to claim 1 obtains an energy distribution of a magnetostrictive guided wave detection signal by suppressing the background noise under certain threshold to reduce the impact of external interference on the signal. The method requires no standard samples and greatly facilitates field application.

The method optionally comprises the steps of:

S9: drawing an energy distribution diagram $z(n)$ according to the energy of processed signals of the selected analysis area obtained by the step S8; and
S10: determining whether a defect exists in a sample according to a distortion characteristic of the energy distribution diagram $z(n)$.

Accordingly, a device for processing magnetostrictively generated guided wave detection signals is claimed in claim 3.

The device optionally comprises a defect detecting unit, connected to the signal processing unit, and configured to draw an energy distribution diagram $z(n)$ according to the energy of processed signals of the selected analysis area and to determine whether a defect exists in a test sample according to a distortion characteristic of the energy distribution diagram $z(n)$.

The principle of the present invention is that a magnetostrctiveguided wave propagating in a sample at a group velocity is reflected, diffracted or transmitted in a different way due to existence of defects and other irregular structures which causes changes in the signal waveform and the propagating energy in corresponding positions. In prior art, a defect-freesample is required for collecting a standard signal, and differential and other processes should be carried out on a test signal and the standard signal, which is unfavorable for field detection. However, the present invention obtains an energy distribution of a magnetostrictive guided wave detection signal by suppressing the background noise under certain threshold to reduce the impact of external interference on the signal, so that the accuracy of magnetostrictive guided wave signal detection is improved by improving the signal to noise ratio. The method requires no standard samples and greatly facilitates field application.

Further description of the invention will be given below in conjunction with accompanying drawings and specific embodiments.

FIG. 1 is a flow chart of a method for processing magnetostrictive guided wave detection signals according to the present invention;

FIG. 2 is a schematic diagram of a device for processing magnetostrictive guided wave detection signals according to the present invention;

FIG. 3 is an experimental layout for detecting a defective standard pipe according to one embodiment of the present invention;

FIG. 4 is a schematic diagram of an original signal detected from a defective pipe with an outside diameter of 25 mm and an inside diameter of 20 mm according to one embodiment of the present invention;

FIG. 5 is a schematic diagram of an analysis signal obtained by capturing an original signal detected from a defective pipe;

FIG. 6 is an energy distribution diagram of signals obtained by processing an analysis signal of a defective pipe by the method of the present invention;

FIG. 7 is an experimental layout for detecting a defect-freestandard pipe according to one embodiment of the present invention;

FIG. 8 is a schematic diagram of an original signal detected from a defect-freepipe with an outside diameter of 25 mm and an inside diameter of 20 mm;

FIG. 9 is a schematic diagram of an analysis signal obtained by capturing an original signal detected from a defect-freepipe; and

FIG. 10 is an energy distribution diagram of signals obtained by processing an analysis signal of a defect-freepipe by the method of the present invention.

For further illustrating the invention, experiments detailing a method and a device for processing magnetostrictive guided wave detection signals are described below. It should be noted that the following examples are intended to describe and not to limit the invention.

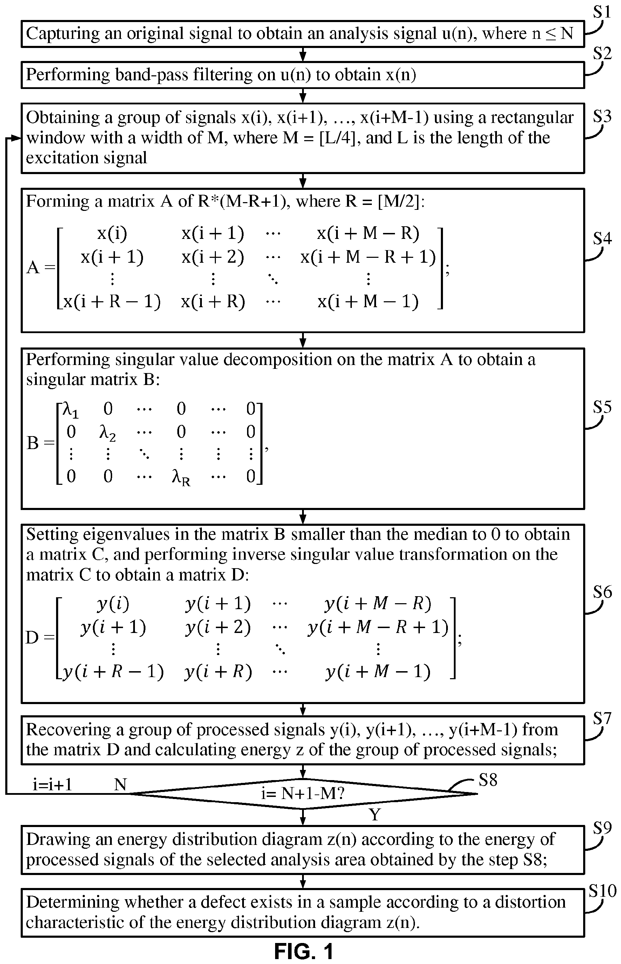

FIG. 1 is a flow chart of a method for improving accuracy of magnetostrictive guided wave detection according to the present invention. As shown in FIG. 1, the method for improving accuracy of magnetostrictive guided wave detection comprises steps of:

S1: obtaining an analysis signal u(n)capturing an original magnetostrictive guided wave detection signal, where $n \leq N$, and N is the length of the analysis signal u(n);

S2: performing band-pass filtering on the analysis signal u(n) to obtain a signal x(n), and initializing i to 0;

S3: obtaining a group of signals x(i), x(i+1), ..., x(i+M-1) using a rectangular window with a width of M, where M = [L/4], and L is the length of the excitation signal;

S4: forming a matrix A of R*(M-R+1), where R = [M/2]:

$$A = \begin{bmatrix} x(i) & x(i+1) & \cdots & x(i+M-R) \\ x(i+1) & x(i+2) & \cdots & x(i+M-R+1) \\ \vdots & \vdots & \ddots & \vdots \\ x(i+R-1) & x(i+R) & \cdots & x(i+M-1) \end{bmatrix};$$

S5: performing singular value decomposition on the matrix A to obtain a singular matrix B:

$$B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix},$$

$\lambda_j$ represents an eigenvalue, and j = 1, 2, ...R;

S6: setting $\lambda_{med}$ to median $(\lambda_1,\lambda_2,...,\lambda_R)$ and setting $\lambda_j$ to 0 under the condition that $\lambda_j < \lambda_{med}$ $(1 \leq j \leq R)$ to obtain a matrix C, namely setting eigenvalues in the matrix B smaller than the median to 0 to obtain the matrix C; and performing inverse singular value transformation on the matrix C to obtain a matrix D:

$$D = \begin{bmatrix} y(i) & y(i+1) & \cdots & y(i+M-R) \\ y(i+1) & y(i+2) & \cdots & y(i+M-R+1) \\ \vdots & \vdots & \ddots & \vdots \\ y(i+R-1) & y(i+R) & \cdots & y(i+M-1) \end{bmatrix};$$

S7: recovering a group of processed signals y(i), y(i+1), ..., y(i+M-1) from the matrix D and calculating energy z of the group of processed signals;

S8: setting i to (i+1) and repeating steps S3-S7 until i = N+1-M to finish calculating the energy of processed signals of the selected analysis area;

S9: drawing an energy distribution diagram z(n) according to the energy of processed signals of the selected analysis area obtained by the step S8; and

S10: determining whether a defect exists in a sample according to a distortion characteristic of the energy distribution diagram z(n).

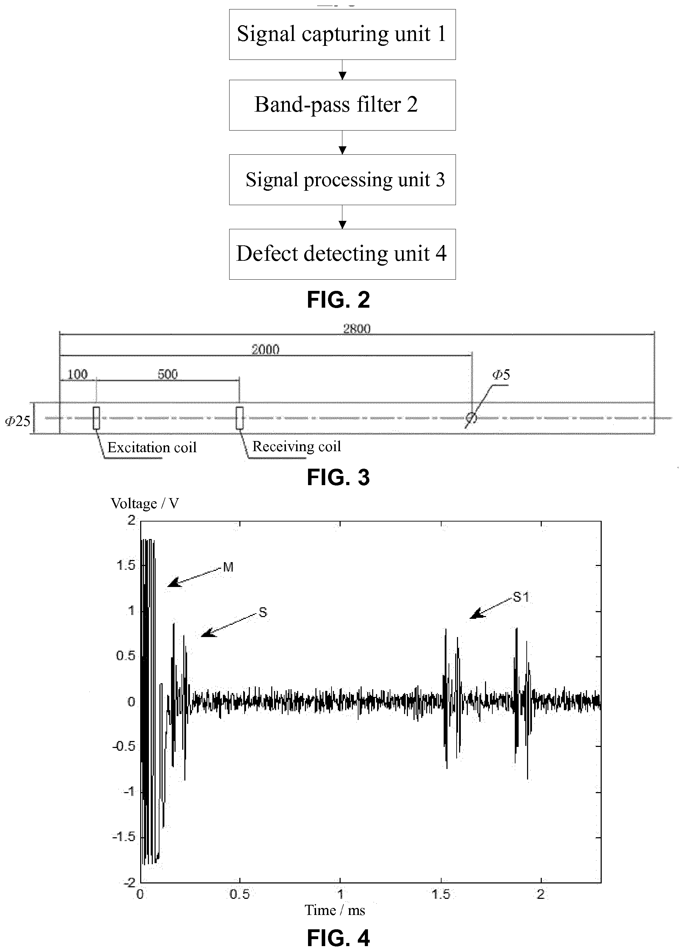

FIG. 2 is a schematic diagram of a device for processing magnetostrictive guided wave detection signals according to the present invention. As shown in FIG. 2, the device for processing magnetostrictive guided wave detection signals comprises a signal capturing unit 1, a band-pass filter 2 connected to the signal capturing unit 1, a signal processing unit 3 connected to the band-pass filter 2, and a defect detecting unit 4 connected to the signal processing unit 3. The signal capturing unit 1 is operable for capturing an original magnetostrictive guided wave detection signal to obtain an analysis signal u(n), where $n \le N$, and N is the length of the analysis signal u(n). The band-pass filter 2 is operable for performing band-pass filtering on the analysis signal u(n) to obtain a signal x(n). The signal processing unit 3 is operable for denoising the signal x(n) and calculating the energy distribution of the denoised signal, where the signal processing unit 3 operates as follows:

obtaining a group of signals x(i), x(i+1), ..., x(i+M-1) using a rectangular window with a width of M, where M = [L/4], and L is the length of the excitation signal; and initializing i to 0;

forming a matrix A of R*(M-R+1), where R = [M/2]:

$$ A = \begin{bmatrix} x(i) & x(i+1) & \cdots & x(i+M-R) \\ x(i+1) & x(i+2) & \cdots & x(i+M-R+1) \\ \vdots & \vdots & \ddots & \vdots \\ x(i+R-1) & x(i+R) & \cdots & x(i+M-1) \end{bmatrix}; $$

performing singular value decomposition on the matrix A to obtain a singular matrix B:

$$ B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix}, $$

$\lambda_j$ represents an eigenvalue, and j = 1, 2, ...R;

setting eigenvalues in the matrix B smaller than the median to 0 to obtain a matrix C, and performing inverse singular value transformation on the matrix C to obtain a matrix D:

$$ D = \begin{bmatrix} y(i) & y(i+1) & \cdots & y(i+M-R) \\ y(i+1) & y(i+2) & \cdots & y(i+M-R+1) \\ \vdots & \vdots & \ddots & \vdots \\ y(i+R-1) & y(i+R) & \cdots & y(i+M-1) \end{bmatrix}; $$

recovering a group of processed signals y(i), y(i+1), ..., y(i+M-1) from the matrix D and calculating energy z of the group of processed signals; and setting i to (i+1) and repeating the steps of obtaining a group of signals x(i), x(i+1), ..., x(i+M-1) using a rectangular window with a width of M and processing the signals until i = N+1-M to finish calculating the energy of processed signals of the selected analysis area.

The defect detecting unit 4 is operable for drawing an energy distribution diagram z(n) according to the energy of processed signals of the selected analysis area and determining whether a defect exists in a test sample according to a distortion characteristic of the energy distribution diagram z(n).

A specific embodiment is provided below according to the present invention.

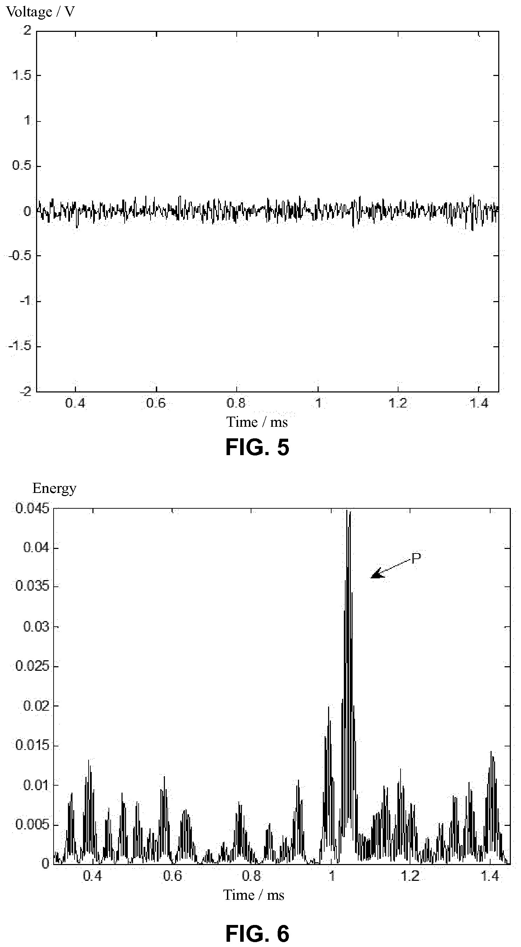

As shown in FIG. 3, a defective heat exchange pipe with an outside diameter of 25 mm, an inside diameter of 20 mm, and a length of 2800 mm is used as a test sample. An excitation coil is 100 mm away from the left end of the pipe, a receiving coil is 600 mm away from the left endof the pipe, and a hole with a diameter of 5 mm exists 2000 mm away from the left endof the pipe. The excitation frequency is 90 kHz, the sampling frequency is 2000 kHz, and the guided wave speed is about 3200 m/s. A schematic diagram of an original signal detected from the defective heat exchange pipe is shown in FIG. 4, which includes an electromagnetic pulse signal M, a signal S passed through a receiving sensor for the first time, and a signal S1 reflected by the rightend for the first time. In order to facilitate analysis, the original signal in FIG. 4 is cut to obtain an analysis signal of the defective pipe ranging from S to S1, which is shown in FIG. 5. A defective signal should exist when t equals 1.03 ms according to calculation, which cannot be identified according to FIG. 5. The analysis signal of the defective pipe is processed by the method of the present invent by selecting a rectangular window with a width of 6 and forming a matrix of 3*4. FIG. 6 is an energy distribution diagram of signals obtained by processing the analysis signal of the defective pipe by the method of the present invention. As shown in FIG. 6, a significant distortion P occurs in the energy at 1.03 ms and the peak value of P mutates greatly. The occurring time matches with the theoretical time, so that it can be concluded that the distortion is caused by the defection.

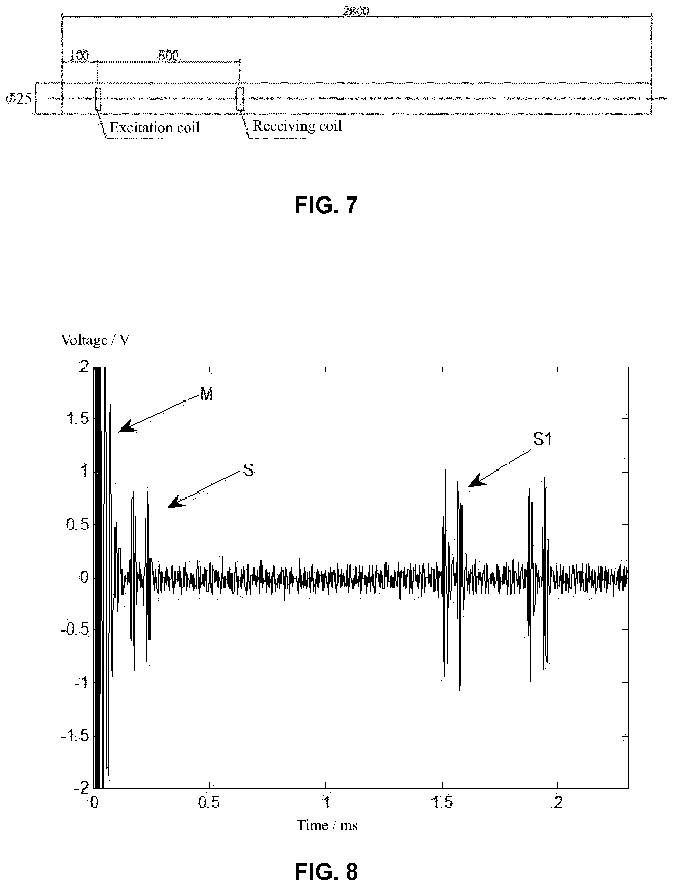

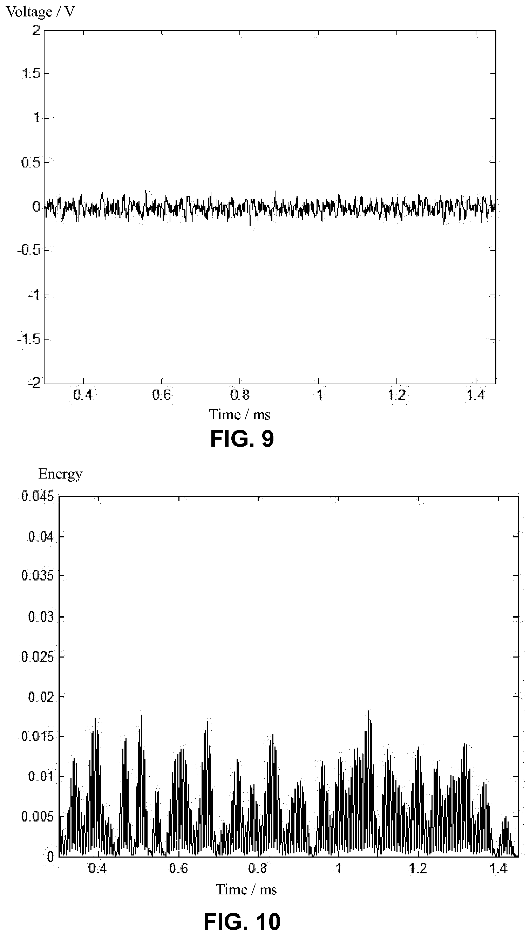

A defect-free heat exchange pipe having the same specifications with the defective heat exchange pipe is provided. The experimental layout, the excitation frequency, the sampling frequency and the guided wave speed stay unchanged. FIG. 7 is the experimental layout for detecting the defect-free pipe. FIG. 8 is a schematic diagram of an original signal detected from the defect-free pipe, which is cut to obtain an analysis signal of the defect-free pipe ranging from S to S1. FIG. 9 is a schematic diagram of the analysis signal obtained by capturing the original signal detected from the defect-free pipe. FIG. 10 is an energy distribution diagram of signals obtained by processing the analysis signal of a defect-free pipe by the method of the present invention, unlike the energy distribution diagram of the defective pipe (FIG. 6), no obvious distortion occurs. Therefore, it can be concluded that the method of the present invention is effective and reliable.

While particular embodiments of the invention have been shown and described, it will be obvious to those skilled in the art that changes and modifications may be made without departing from the invention in its broader aspects, and therefore, the aim in the appended claims is to cover all such changes and modifications as fall within the scope of the invention.

## Claims

1. A method for processing magnetostrictively generated guided wave detection signals, the method comprising steps of:

   S1: obtaining an analysis signal u(n) from capturing an original magnetostrictively generated guided wave detection signal, where $n \leq N$, and N is the length of the analysis signal u(n);

   S2: performing band-pass filtering on the analysis signal u(n) to obtain a signal x(n), and initializing i to 0;

   S3: obtaining a group of signals x(i), x(i+1), ..., x(i+M-1) using a rectangular window with a width of M, where M = [L/4], and L is the length of the excitation signal;

   S4: forming a matrix A of R*(M-R+1), where R = [M/2]:

$$A = \begin{bmatrix} x(i) & x(i+1) & \cdots & x(i+M-R) \\ x(i+1) & x(i+2) & \cdots & x(i+M-R+1) \\ \vdots & \vdots & \ddots & \vdots \\ x(i+R-1) & x(i+R) & \cdots & x(i+M-1) \end{bmatrix};$$

   S5: performing singular value decomposition on the matrix A to obtain a singular matrix B:

$$B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix},$$

   $\lambda_j$ represents an eigenvalue, and j = 1, 2, ...R;

   S6: setting eigenvalues in the matrix B smaller than the median to 0 to obtain a matrix C, and performing inverse singular value transformation on the matrix C to obtain a matrix D:

$$D = \begin{bmatrix} y(i) & y(i+1) & \cdots & y(i+M-R) \\ y(i+1) & y(i+2) & \cdots & y(i+M-R+1) \\ \vdots & \vdots & \ddots & \vdots \\ y(i+R-1) & y(i+R) & \cdots & y(i+M-1) \end{bmatrix};$$

S7: recovering a group of processed signals y(i), y(i+1), ..., y(i+M-1) from the matrix D and calculating energy z of the group of processed signals; and

S8: setting i to (i+1) and repeating steps S3-S7 until i= N+1-M to finish calculating the energy of processed signals of the selected analysis area.

2. The method of claim 1, further comprising steps of:

S9: drawing an energy distribution diagram z(n) according to the energy of processed signals of the selected analysis area obtained by the step S8; and

S10: determining whether a defect exists in a sample according to a distortion characteristic of the energy distribution diagram z(n).

3. A device for processing magnetostrictively generated guided wave detection signals, the device comprising:

an excitation coil, configured to excite an original magnetostrictively generated guided wave detection signal;

a receiving coil (1), configured to capture the original magnetostrictively generated guided wave detection signal to obtain an analysis signal u(n), where $n \le N$, and N is the length of the analysis signal u(n);

a band-pass filter (2), connected to the receiving coil (1) and configured to perform band-pass filtering on the analysis signal u(n) to obtain a signal x(n); and

a signal processing unit (3), connected to the band-pass filter (2) and configured to denoise the signal x(n) and to calculate the energy distribution of the denoised signal; where the signal processing unit (3) is configured to operate as follows:

obtaining a group of signals x(i), x(i+1), ..., x(i+M-1) using a rectangular window with a width of M, where M = [L/4], and L is the length of the excitation signal; and initializing I to 0;

forming a matrix A of R*(M-R+1), where R = [M/2]:

$$A = \begin{bmatrix} x(i) & x(i+1) & \cdots & x(i+M-R) \\ x(i+1) & x(i+2) & \cdots & x(i+M-R+1) \\ \vdots & \vdots & \ddots & \vdots \\ x(i+R-1) & x(i+R) & \cdots & x(i+M-1) \end{bmatrix};$$

performing singular value decomposition on the matrix A to obtain a singular matrix B:

$$B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix},$$

$\lambda_j$ represents an eigenvalue, and j = 1, 2, ... R;

setting eigenvalues in the matrix B smaller than the median to 0 to obtain a matrix C, and performing inverse singular value transformation on the matrix C to obtain a matrix D:

$$D = \begin{bmatrix} y(i) & y(i+1) & \cdots & y(i+M-R) \\ y(i+1) & y(i+2) & \cdots & y(i+M-R+1) \\ \vdots & \vdots & \ddots & \vdots \\ y(i+R-1) & y(i+R) & \cdots & y(i+M-1) \end{bmatrix};$$

recovering a group of processed signals y(i), y(i+1), ..., y(i+M-1) from the matrix D and calculating energy z of the group of processed signals; and

setting i to (i+1) and repeating the steps of obtaining a group of signals x(i), x(i+1), ..., x(i+M-1) using a rectangular window with a width of M and processing the signals until i = N+1-M to finish calculating the energy of processed signals of the selected analysis area.

**4.** The device of claim 3, further comprising a defect detecting unit (4) connected to the signal processing unit (3), and configured to draw an energy distribution diagram z(n) according to the energy of processed signals of the selected analysis area and to determine whether a defect exists in a test sample according to a distortion characteristic of the energy distribution diagram z(n).

**Patentansprüche**

**1.** Verfahren zum Verarbeiten von magnetostriktiv erzeugten, geführten Wellendetektionssignalen, wobei das Verfahren die folgenden Schritte umfasst:

S1: Erhalten eines Analysesignals u(n) aus dem Erfassen eines ursprünglichen, magnetostriktiv erzeugten, geführten Wellendetektionssignals, wobei $n \le N$ und N die Länge des Analysesignals u(n) ist;

S2: Durchführen einer Bandpassfilterung an dem Analysesignal u(n) zum Erhalten eines Signals x(n) und Initialisieren von i auf 0;

S3: Erhalten einer Gruppe von Signalen x(i), x(i+1), ...., x(i+M-1) unter Verwendung eines rechteckigen Fensters mit einer Breite von M, wobei M = [L/4] und L die Länge des Anregungssignals ist;

S4: Bilden einer Matrix A aus R*(M-R+1), wobei R = [M/2] ist:

$$A = \begin{bmatrix} x(i) & x(i+1) & \cdots & x(i+M-R) \\ x(i+1) & x(i+2) & \cdots & x(i+M-R+1) \\ \vdots & \vdots & \ddots & \vdots \\ x(i+R-1) & x(i+R) & \cdots & x(i+M-1) \end{bmatrix};$$

S5: Durchführen einer Singulärwertzerlegung an der Matrix A, um eine singuläre Matrix B zu erhalten:

$$B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix},$$

wobei $\lambda_j$ einen Eigenwert darstellt, und j = 1, 2, ...R ist;

S6: Festsetzen von Eigenwerten in der Matrix B, die kleiner als der Median sind, auf 0, um eine Matrix C zu erhalten, und Durchführen einer inversen Singulärwerttransformation an der Matrix C, um eine Matrix D zu erhalten:

$$D = \begin{bmatrix} y(i) & y(i+1) & \cdots & y(i+M-R) \\ y(i+1) & y(i+2) & \cdots & y(i+M-R+1) \\ \vdots & \vdots & \ddots & \vdots \\ y(i+R-1) & y(i+R) & \cdots & y(i+M-1) \end{bmatrix};$$

S7: Gewinnen einer Gruppe von verarbeiteten Signalen y(i), y(i+1), ..., y(i+M-1) aus der Matrix D und Berechnen der Energie z der Gruppe von verarbeiteten Signalen; und

S8: Festsetzen von i auf (i+1) und Wiederholen der Schritte S3-S7 bis i = N+1-M ist, um die Berechnung der Energie der verarbeiteten Signale des ausgewählten Analysebereichs abzuschließen.

**2.** Verfahren nach Anspruch 1, ferner umfassend die Schritte von:

S9: Zeichnen eines Energieverteilungsdiagramms z(n) gemäß der Energie der verarbeiteten Signale des ausgewählten Analysebereichs, der durch den Schritt S8 erhalten wurde; und

S10: Bestimmen, ob ein Defekt in einer Probe gemäß einer Verzerrungscharakteristik des Energieverteilungsdiagramms z(n) vorliegt.

**3.** Vorrichtung zum Verarbeiten von magnetostriktiv erzeugten, geführten Wellendetektionssignalen, wobei die Vorrichtung umfasst:

eine Erregungsspule, die konfiguriert ist, um ein ursprünglich magnetostriktiv erzeugtes, geführtes Wellenerfassungssignal zu erregen;

eine Empfangsspule (1), die konfiguriert ist, um das ursprüngliche magnetostriktiv erzeugte, geführte Wellendetektionssignal zu erfassen, um ein Analysesignal u(n) zu erhalten, wobei $n \leq N$ und N die Länge des Analysesignals u(n) ist;

ein Bandpassfilter (2), das mit der Empfangsspule (1) verbunden und konfiguriert ist, um eine Bandpassfilterung des Analysesignals u(n) durchzuführen, um ein Signal x(n) zu erhalten; und

eine Signalverarbeitungseinheit (3), die mit dem Bandpassfilter (2) verbunden und konfiguriert ist, um das Signal x(n) zu entrauschen und um die Energieverteilung des entrauschten Signals zu berechnen; wobei die Signalverarbeitungseinheit (3) konfiguriert ist, um wie folgt zu funktionieren:

Erhalten einer Gruppe von Signalen x(i), x(i+1), ..., x(i+M-1) unter Verwendung eines rechteckigen Fensters mit einer Breite von M, wobei M = [L/4] und L die Länge des Anregungssignals ist; und Initialisieren von i auf 0;

Bilden einer Matrix A aus R*(M-R+1), wobei R = [M/2] ist:

$$A = \begin{bmatrix} x(l) & x(l+1) & \cdots & x(l+M-R) \\ x(l+1) & x(l+2) & \cdots & x(l+M-R+1) \\ \vdots & \vdots & \ddots & \vdots \\ x(l+R-1) & x(l+R) & \cdots & x(l+M-1) \end{bmatrix};$$

Durchführen einer Singulärwertzerlegung an der Matrix A, um eine singuläre Matrix B zu erhalten:

$$B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix},$$

wobei $\lambda_j$ einen Eigenwert darstellt, und j = 1,2,...R ist;

Festsetzen von Eigenwerten in der Matrix B, die kleiner als der Median sind, auf 0, um eine Matrix C zu erhalten, und Durchführen einer inversen Singulärwerttransformation an der Matrix C, um eine Matrix D zu erhalten:

$$D = \begin{bmatrix} y(l) & y(l+1) & \cdots & y(l+M-R) \\ y(l+1) & y(l+2) & \cdots & y(l+M-R+1) \\ \vdots & \vdots & \ddots & \vdots \\ y(l+R-1) & y(l+R) & \cdots & y(l+M-1) \end{bmatrix};$$

Gewinnen einer Gruppe von verarbeiteten Signalen y(i), y(i+1), ..., y(i+M-1) aus der Matrix D und Berechnen der Energie z der Gruppe von verarbeiteten Signalen; und

Festsetzen von i auf (i+1) und Wiederholen der Schritte zum Erhalten einer Gruppe von Signalen x(i), x(i+1), ..., x(i+M-1) unter Verwendung eines rechteckigen Fensters mit einer Breite von M und Verarbeiten der Signale bis i = N+1-M ist, um die Berechnung der Energie der verarbeiteten Signale des ausgewählten Analysebereichs abzuschließen.

**4.** Vorrichtung nach Anspruch 3, die ferner eine Fehlererkennungseinheit (4) umfasst, die mit der Signalverarbeitungseinheit (3) verbunden und konfiguriert ist, um ein Energieverteilungsdiagramm z(n) gemäß der Energie der verarbeiteten Signale des ausgewählten Analysebereichs zu zeichnen und um zu bestimmen, ob ein Fehler in einem Prüfmuster gemäß einer Verzerrungscharakteristik des Energieverteilungsdiagramms z(n) vorliegt.

**Revendications**

1. Procédé de traitement de signaux de détection de guide d'onde généré de façon magnétostrictive, le procédé comprenant les étapes suivantes :

   S1 : obtention d'un signal d'analyse u(n) de la capture d'un signal de détection de guide d'onde généré de façon magnétostrictive original, où $n \leq N$, et N est la longueur du signal d'analyse u(n) ;

   S2 : réalisation d'un filtrage passe bande sur le signal d'analyse u(n) pour obtenir un signal x(n), et initialisation de i à 0 ;

   S3 : obtention d'un groupe de signaux x(i), x(i+1), ..., x(i+M-1) en utilisant une fenêtre rectangulaire ayant une largeur de M, où M = [L/4], et L est la longueur du signal d'excitation ;

   S4 : formation d'une matrice A de R*(M-R+1), où R = [M/2] :

$$A = \begin{bmatrix} x(i) & x(i+1) & \cdots & x(i+M-R) \\ x(i+1) & x(i+2) & \cdots & x(i+M-R+1) \\ \vdots & \vdots & \ddots & \vdots \\ x(i+R-1) & x(i+R) & \cdots & x(i+M-1) \end{bmatrix};$$

   S5 : réalisation d'une décomposition en valeurs singulières sur la matrice A pour obtenir une matrice singulière B :

$$B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix},$$

   $\lambda_j$ représente une valeur propre, et j = 1, 2, ... R ;

   S6 : définition de valeurs propres dans la matrice B inférieures à la médiane à 0 pour obtenir une matrice C, et réalisation d'une transformation inverse des valeurs singulières sur la matrice C pour obtenir une matrice D :

$$D = \begin{bmatrix} y(i) & y(i+1) & \cdots & y(i+M-R) \\ y(i+1) & y(i+2) & \cdots & y(i+M-R+1) \\ \vdots & \vdots & \ddots & \vdots \\ y(i+R-1) & y(i+R) & \cdots & y(i+M-1) \end{bmatrix};$$

   S7 : récupération d'un groupe de signaux traités y(i), y(i+1), ..., y(i+M-1) de la matrice D et calcul de l'énergie z du groupe de signaux traités ; et

   S8 : définition de i à (i+1) et répétition des étapes S3-S7 jusqu'à ce que i= N+1-M pour finir de calculer l'énergie des signaux traités de la zone d'analyse sélectionnée.

2. Procédé selon la revendication 1, comprenant en outre les étapes suivantes :

   S9 : dessin d'un diagramme de distribution de l'énergie z(n) en fonction de l'énergie des signaux traités de la zone d'analyse sélectionnée obtenue par l'étape S8 ; et

   S10 : détermination du fait qu'un défaut existe dans un échantillon en fonction d'une caractéristique de distorsion du diagramme de distribution d'énergie z(n).

3. Dispositif de traitement de signaux de détection de guide d'onde générés de façon magnétostrictive, le dispositif comprenant :

   une bobine d'excitation, configurée pour exciter un signal de détection d'onde guidée généré de façon magnétostrictive ;

   une bobine de réception (1), configurée pour capturer le signal de détection d'onde guidée généré de façon magnétostrictive pour obtenir un signal d'analyse u(n), où $n \leq N$, et N est la longueur du signal d'analyse u(n) ;

   un filtre passe bande (2), relié à la bobine de réception (1) et configuré pour réaliser le filtrage passe bande sur le signal d'analyse u(n) pour obtenir un signal x(n) ; et

et une unité de traitement du signal (3), reliée au filtre passe bande (2) et configuré pour débruiter le signal x(n) et pour calculer la distribution d'énergie du signal débruité ; où l'unité de traitement du signal (3) est configurée pour fonctionner de la manière suivante :

obtention d'un groupe de signaux x(i), x(i+1), ..., x(i+M-1) en utilisant une fenêtre rectangulaire ayant une largeur de M, où M = [L/4], et L est la longueur du signal d'excitation ; et initialisation de I à 0 ;

formation d'une matrice A de R*(M-R+1), où R = [M/2] :

$$A = \begin{bmatrix} x(i) & x(i+1) & \cdots & x(i+M-R) \\ x(i+1) & x(i+2) & \cdots & x(i+M-R+1) \\ \vdots & \vdots & \ddots & \vdots \\ x(i+R-1) & x(i+R) & \cdots & x(i+M-1) \end{bmatrix};$$

réalisation d'une décomposition en valeurs singulières sur la matrice A pour obtenir une matrice singulière B :

$$B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix},$$

$\lambda_j$ représente une valeur propre, et j = 1, 2, ... R ;

définition des valeurs propres dans la matrice B inférieures à la médiane à 0 pour obtenir une matrice C, et réalisation d'une transformation inverse des valeurs singulières sur la matrice C pour obtenir une matrice D :

$$D = \begin{bmatrix} y(i) & y(i+1) & \cdots & y(i+M-R) \\ y(i+1) & y(i+2) & \cdots & y(i+M-R+1) \\ \vdots & \vdots & \ddots & \vdots \\ y(i+R-1) & y(i+R) & \cdots & y(i+M-1) \end{bmatrix};$$

récupération d'un groupe de signaux traités y(i), y(i+1), ..., y(i+M-1) de la matrice D et calcul de l'énergie z du groupe de signaux traités ; et

définition de i à (i+1) et répétition des étapes d'obtention d'un groupe de signaux x(i), x(i+1), ..., ..., x(i+M-1) en utilisant une fenêtre rectangulaire avec une largeur de M et traitement des signaux jusqu'à ce que i = N+1-M pour finir de calculer l'énergie des signaux traités de la zone d'analyse sélectionnée.

4. Dispositif selon la revendication 3, comprenant en outre une unité de détection de défauts (4) reliée à l'unité de traitement du signal (3), et configurée pour tracer un diagramme de distribution d'énergie z(n) selon l'énergie de signaux traités de la zone d'analyse sélectionnée et pour déterminer si un défaut existe dans un échantillon de test en fonction d'une caractéristique de distorsion du diagramme de distribution d'énergie z(n).

Capturing an original signal to obtain an analysis signal u(n), where $n \leq N$ — S1

Performing band-pass filtering on u(n) to obtain x(n) — S2

Obtaining a group of signals x(i), x(i+1), …, x(i+M-1) using a rectangular window with a width of M, where M = [L/4], and L is the length of the excitation signal — S3

Forming a matrix A of R*(M-R+1), where R = [M/2]:

$$A = \begin{bmatrix} x(i) & x(i+1) & \cdots & x(i+M-R) \\ x(i+1) & x(i+2) & \cdots & x(i+M-R+1) \\ \vdots & \vdots & \ddots & \vdots \\ x(i+R-1) & x(i+R) & \cdots & x(i+M-1) \end{bmatrix};$$

— S4

Performing singular value decomposition on the matrix A to obtain a singular matrix B:

$$B = \begin{bmatrix} \lambda_1 & 0 & \cdots & 0 & \cdots & 0 \\ 0 & \lambda_2 & \cdots & 0 & \cdots & 0 \\ \vdots & \vdots & \ddots & \vdots & \vdots & \vdots \\ 0 & 0 & \cdots & \lambda_R & \cdots & 0 \end{bmatrix},$$

— S5

Setting eigenvalues in the matrix B smaller than the median to 0 to obtain a matrix C, and performing inverse singular value transformation on the matrix C to obtain a matrix D:

$$D = \begin{bmatrix} y(i) & y(i+1) & \cdots & y(i+M-R) \\ y(i+1) & y(i+2) & \cdots & y(i+M-R+1) \\ \vdots & \vdots & \ddots & \vdots \\ y(i+R-1) & y(i+R) & \cdots & y(i+M-1) \end{bmatrix};$$

— S6

Recovering a group of processed signals y(i), y(i+1), …, y(i+M-1) from the matrix D and calculating energy z of the group of processed signals; — S7

i=i+1　　N　　← i= N+1-M? — S8

Y

Drawing an energy distribution diagram z(n) according to the energy of processed signals of the selected analysis area obtained by the step S8; — S9

Determining whether a defect exists in a sample according to a distortion characteristic of the energy distribution diagram z(n). — S10

**FIG. 1**

| Signal capturing unit 1 |
|---|

↓

| Band-pass filter 2 |
|---|

↓

| Signal processing unit 3 |
|---|

↓

| Defect detecting unit 4 |
|---|

**FIG. 2**

**FIG. 3**

**FIG. 4**

FIG. 5

FIG. 6

**FIG. 7**

**FIG. 8**

Voltage / V

Time / ms

**FIG. 9**

Energy

Time / ms

**FIG. 10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 101393173 A
- CN 101451976 A
- CN 101710103 A
- CN 102520057 A
- CN 101126743 A

### Non-patent literature cited in the description

- **YI LU et al.** Robust decision making in damage detection using piezoelectric transducers and lamb wave propagation. SPIE, 31 December 2007